# EUROPEAN PATENT SPECIFICATION

(11) **EP 3 902 085 B1**
(45) Date of publication and mention of the grant of the patent: **08.03.2023**
(21) Application number: 20171138.9
(22) Date of filing: 23.04.2020
(51) Int. Cl.: H02J 3/38, H02J 7/02, H02J 7/35, H02J 50/00, H02J 50/10, H02J 50/60

(54) **A WIRELESS POWER TRANSFER PAD**
DRAHTLOSES LEISTUNGSÜBERTRAGUNGSPAD
TAMPON DE TRANSFERT D'ÉNERGIE SANS FIL

(43) Date of publication of application: 27.10.2021
(73) Proprietor: Ningbo Geely Automobile Research & Development Co. Ltd., Hangzhou Bay New District Ningbo 315336 (CN); Zhejiang Geely Holding Group Co., Ltd., Hangzhou, Zhejiang 310051 (CN)
(72) Inventor: BERGGREN, Alexander, 417 44 GÖTEBORG (SE); SAMUELSSON, Gabriel, 441 96 ALINGSÅS (SE)
(74) Representative: Zacco Sweden AB

(56) References cited:
- WO-A1-2019/204379
- KR-B1- 101 671 992
- US-A1- 2014 181 782
- US-A1- 2018 076 671
- US-A1- 2019 006 826

## Description

### TECHNICAL FIELD

The present disclosure relates to a wireless power transfer pad for wireless charging of a vehicle electrical storage system. The disclosure further relates to a method for wireless charging of an electrical storage system of a hybrid electric or electric vehicle.

The wireless power transfer pad according to the disclosure will be described primarily in relation to charging of the electrical storage system of a car, but the wireless power transfer pad is not restricted to this particular vehicle and may alternatively be used for charging the electrical storage system of other types of vehicles, such as trucks, buses, rail vehicles, flying vehicles, off-road vehicles, mining vehicles, agriculture vehicles, working vehicles, motorcycles or the like.

### BACKGROUND

Charging of plug-in electric vehicles may for example be performed via a charging connector of a stationary charging station being connected with a dedicated connector on the vehicle. Alternatively, charging may be performed wirelessly via a wireless power transfer pad as described in for example US 2019/0006826 A1. However, high-power charging of electrical vehicles generally involves cost associated with production and distribution of electrical energy, e.g. cost associated with long-term operation of electrical energy power plants and development and maintenance of an electrical power grid required for distribution of high power electrical energy from remote electrical power plants to each individual electrical charging station.

There is thus a demand for improved charging of electrical vehicles in terms of userfriendliness, low-level electrical power transmission and low electrical energy charging cost.

### SUMMARY

An object of the present disclosure is to provide a wireless power transfer pad for wireless charging of a vehicle electrical storage system wherein the previously mentioned problems are avoided. This object is at least partly achieved by the features of the independent claims.

According to a first aspect of the present disclosure, there is provided a wireless power transfer pad for wireless charging of a vehicle electrical storage system. The wireless power transfer pad comprising an oscillating electromagnetic field generating device configured for transmitting energy to a wireless power receiver associated with the vehicle, a foreign object detection arrangement including a plurality of foreign object detection coils and a solar panel arrangement including a photovoltaic substrate with a front side and a rear side, a front side electrode arrangement and a rear side electrode arrangement, wherein the foreign object detection coils are configured to function also as the front side electrode arrangement.

According to a second aspect of the present disclosure, there is provided a method for wireless charging of an electrical storage system of a hybrid electric or electric vehicle. The method comprising a first step of supplying electrical power generated by a solar panel arrangement integrated in a stationary wireless power transfer pad to an electrical grid or a local stationary electrical storage system, wherein the solar panel arrangement includes a photovoltaic substrate with a front side and a rear side, a front side electrode arrangement and a rear side electrode arrangement. The method further comprises a second step of positioning the hybrid electric or electric vehicle over the wireless power transfer pad, such that the wireless power transfer pad is arranged adjacent a wireless power receiver associated with the vehicle. The method further comprises a third step of detecting, by means of a foreign object detection arrangement integrated in the wireless power transfer pad, whether any foreign object is located on the wireless power transfer pad, wherein the foreign object detection arrangement includes a plurality of foreign object detection coils, which are configured to function also as said front side electrode arrangement. Finally, if no foreign object is detected, the method comprises a step of initiating charging of the electrical storage system of the hybrid electric or electric vehicle with electrical energy from the electrical grid or the local stationary electrical storage system by generating an oscillating electromagnetic field generating in the wireless power transfer pad and thereby inducing an electrical current in the wireless power receiver.

In this way, the use-friendliness associated with wireless charging of the vehicle is combined with local electrical power generation, thereby enabling reduced cost for electrical energy generation and reduced load on the electrical power grid. Moreover, the wireless power transfer pad is design for utilizing the integrated foreign object detection system of the wireless power transfer pad for two purposes, namely foreign object detection of metal objects, as well as front side electrode arrangement of the photovoltaic solar panel arrangement.

In other words, the wireless power transfer pad according to the disclosure enables reduced load on supply grid network, reduced need for costly investments in supply grid network, reduced cost per kilowatt-hour for the user while providing a userfriendly solution for charging of the electric vehicle without need for handling of a charging connector.

Further advantages are achieved by implementing one or several of the features of the dependent claims.

In some example embodiments, the oscillating electromagnetic field generating device includes at least one coil. This enables low-cost and efficient wireless transfer of energy to a corresponding receiver coil arranged in the vehicle.

In some example embodiments, the oscillating electromagnetic field generating device is configured to function also as the rear side electrode arrangement. Thanks to the dual functionality of the oscillating electromagnetic field generating device, a more cost-efficient solution of the wireless power transfer pad is accomplished.

In some example embodiments, the wireless power transfer pad further comprises an electrically conductive sheet configured for serving as the rear side electrode arrangement. Thereby, the electrical contact surface between the rear side electrode arrangement and photovoltaic substrate may be increased, and thereby also the overall energy-generation efficiency of the wireless power transfer pad.

In some example embodiments, the electrically conductive sheet is arranged between the photovoltaic substrate and the oscillating electromagnetic field generating device. Thereby, large contact surface between the rear side electrode arrangement and photovoltaic substrate is accomplished.

In some example embodiments, the wireless power transfer pad further comprises an anti-reflection layer provided on front side of photovoltaic substrate. Thereby, higher energy-generation efficiency is accomplished.

In some example embodiments, the wireless power transfer pad further comprises an anti-reflection layer provided on the front cover. Thereby, higher energy-generation efficiency is accomplished.

In some example embodiments, the wireless power transfer pad further comprises a front side cover and a rear side cover for encapsulating and protecting the oscillating electromagnetic field generating device, the foreign object detection arrangement, and the photovoltaic substrate. An outer cover provides protection against mechanical impact, heavy load and moisture, as well as electrical protection for living objects.

In some example embodiments, the front cover is transparent and penetrable for solar radiation. Thereby, higher energy-generation efficiency is accomplished.

In some example embodiments, the photovoltaic substrate has a projected and/or recessed surface structure serving as holder for the foreign object detection coils and/or a coil of the oscillating electromagnetic field generating device. Thereby, assembly and manufacturing is simplified and the risk for subsequent displacement of the foreign object detection coils and/or coil of the oscillating electromagnetic field generating device is reduced.

In some example embodiments, the front side electrode arrangement is configured for enabling a flow of electrons between the front side of the photovoltaic substrate and the front side electrode arrangement, and the rear side electrode arrangement is configured for enabling a flow of electrons between the rear side of the photovoltaic substrate and the rear side electrode arrangement.

In some example embodiments, a front side layer of the photovoltaic substrate is p-doped and a rear side layer of the photovoltaic substrate is n-doped, or a front side layer of the photovoltaic substrate is n-doped and a rear side layer of the photovoltaic substrate is p-doped.

In some example embodiments, the foreign object detection arrangement includes an array of at least 4, specifically at least 12, and more specifically at least 20 individual foreign object detection coils distributed over a top area of the wireless power transfer pad. Thereby, an appropriate density level of foreign object detection coils may be selected for accomplishing a desired level of foreign object detection accuracy and reliability.

The disclosure also relates to a system comprising a wireless power transfer pad as described above, and a hybrid electric or electric vehicle with an electrical storage system and a wireless power receiver, wherein an oscillating electromagnetic field generating device of the wireless power transfer pad is configured for transmitting energy to the wireless power receiver of the vehicle.

Further features and advantages of the invention will become apparent when studying the appended claims and the following description. The skilled person in the art realizes that different features of the present disclosure may be combined to create embodiments other than those explicitly described hereinabove and below, without departing from the scope of the present disclosure.

### BRIEF DESCRIPTION OF DRAWINGS

The disclosure will be described in detail in the following, with reference to the attached drawings, in which
- Fig. 1: shows a side view of a system including an electrical vehicle and a wireless power transmitter,
- Fig. 2a: shows schematically an exploded view of an example embodiment of the wireless power transfer pad,
- Fig. 2b: shows schematically a cross-sectional view of the pad of figure 2a in assembled state,
- Fig. 3a-3d: shows schematically different views of a further example embodiment of the wireless power transfer pad,
- Fig. 4-6: shows schematically various aspects and design solutions of the photovoltaic solar panel arrangement,
- Fig. 7: shows schematically a front side cover having an anti-reflection coating,
- Fig. 8: shows schematically a further example embodiment of the wireless power transfer pad,
- Fig. 9a-9b: show schematically different views of still a further example embodiment of the wireless power transfer pad,
- Fig. 10a-10b: show schematically different views of still a further example embodiment of the wireless power transfer pad,
- Fig. 11a-12b: show schematically various example embodiments of the induction coil configuration,
- Fig. 13a-13b: shows schematically a first example embodiment of a the foreign object detection arrangement,
- Fig. 14a-14b: shows schematically a further example embodiment of a the foreign object detection arrangement,
- Fig. 15a-15c: shows schematically three further example embodiments of a the foreign object detection arrangement,
- Fig. 16: shows the basic steps of the method according to the disclosure.

### DESCRIPTION OF EXAMPLE EMBODIMENTS

Various aspects of the disclosure will hereinafter be described in conjunction with the appended drawings to illustrate and not to limit the disclosure, wherein like designations denote like elements, and variations of the described aspects are not restricted to the specifically shown embodiments, but are applicable on other variations of the disclosure.

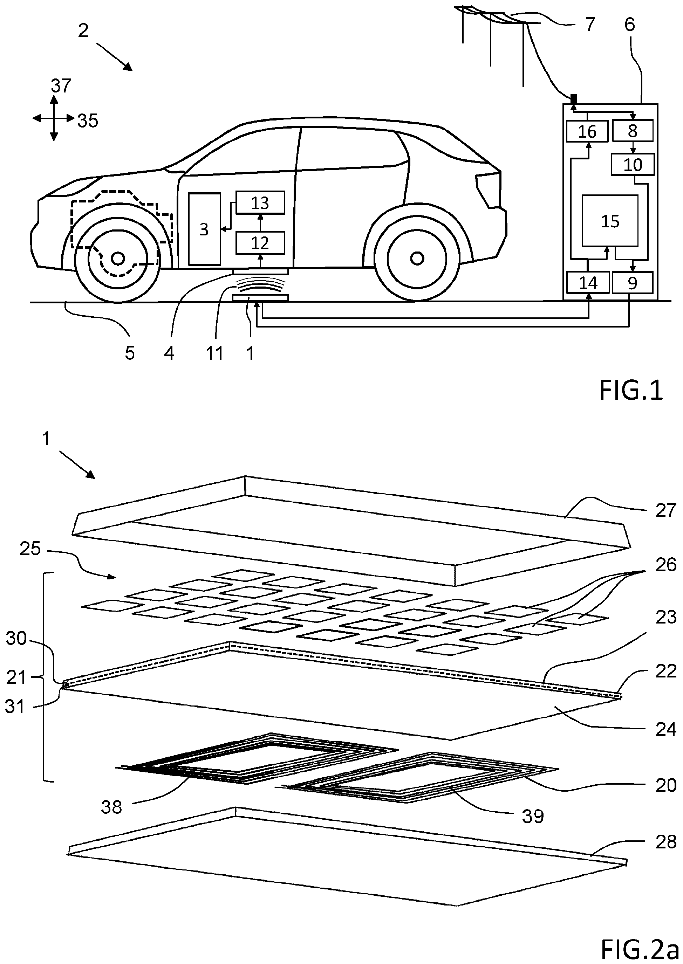

Figure 1 schematically shows a system comprising a wireless power transfer pad 1 and a hybrid electric or electric vehicle 2 with an electrical storage system 3 and a wireless power receiver 4, wherein an oscillating electromagnetic field generating device of the wireless power transfer pad 1 is configured for transmitting energy to the wireless power receiver 4 of the vehicle 2.

The system is for example suitable for wireless charging of the electrical storage system 3 of the vehicle 1 during vehicle stillstand, such as during vehicle parking or at vehicle temporary stillstand in front of traffic lights, etc.

The electrical storage system (ESS) 3 may for example include one or more battery modules, one or more super capacitors, a combination thereof, or the like. The battery technology may for example be of the Lithium-ion type. The nominal voltage of the ESS may be for example 24 volt (V) or 48V, or any voltage level in the range of 12 - 60V for a mild hybrid electric vehicle, and the nominal voltage of the ESS may be for example in the range of about 200 - 2000V, specifically about 350 - 1000V, for a full electric vehicle.

The wireless power transfer pad 1 is typically, but not strictly necessary, stationary located at a suitable location on the ground 5 and connected to a power supply device 6 that is configured to provide the necessary electrical power to the wireless power transfer pad 1.

The power supply device 6 may for example be connected to a power source, such as an electrical grid 7 for supply of electrical energy, such as single phase or three phase AC or DC power. In case the electrical grid supplies AC, the power supply device 6 may include a rectifier unit 8 and a subsequent power-supplying unit 9, which is configured to be connected to the oscillating electromagnetic field generating device, such as an induction coil, of the wireless power transfer pad 1. The power-supplying unit 9 may for example provide high frequency AC. A DC/DC converter 10 may be provided between the rectifier unit 8 and the power-supplying unit 9 to adjust the voltage level if necessary, depending on the specific circumstances of each implementation.

More in detail, the power-supplying unit 9 may for example include a resonance capacitor that together with the induction coil define a power-supplying-side resonance circuit. The power-supplying unit 9 converts DC power obtained from the rectifier unit 8 or DC/DC converter 10 into high frequency AC power having a higher frequency than the AC power supplied via the grid 7, for example in the range of 10 - 150 kHz.

The high-frequency AC supplied from the power-supplying unit 6 to the induction coil of the wireless power transfer pad 1 generates an oscillating magnetic field 11, which in turn induces a corresponding AC voltage in a corresponding coil arranged in the wireless power receiver 4 of the vehicle 2, thereby providing the desired wireless transfer of energy to the vehicle 1.

In the example embodiment of figure 1, the wireless power receiver 4 is connected to a rectified unit 12 for converting the induced high frequency AC of the wireless power receiver 4 to DC, which subsequently may be used for charging the ESS 3.

A DC/DC converter 13 may be provided between the rectifier unit 12 and the ESS 3 to adjust the voltage level if necessary, depending on the specific circumstances of each implementation.

The wireless power transfer pad 1 further comprises a solar panel arrangement configured for generating electrical power upon being illuminated by light, e.g. sun light.

In the example embodiment of figure 1, the DC electrical power generated by the solar panel arrangement may be supplied to the electrical grid 7, for example via a DC/DC converter 14 and a subsequent inverter 16 for converting the DC to AC. Alternatively, or in combination with above, the power supply device 6 may include an electrical storage system (EES) 15, such as a battery.

The layout of the wireless power transfer and charging arrangement described with reference to figure 1 is merely one example embodiment of such an arrangement, and many alternative arrangements are possible. For example, in certain implementations, the power supply device 6 may be partly and completely integrated in the wireless power transfer pad 1.

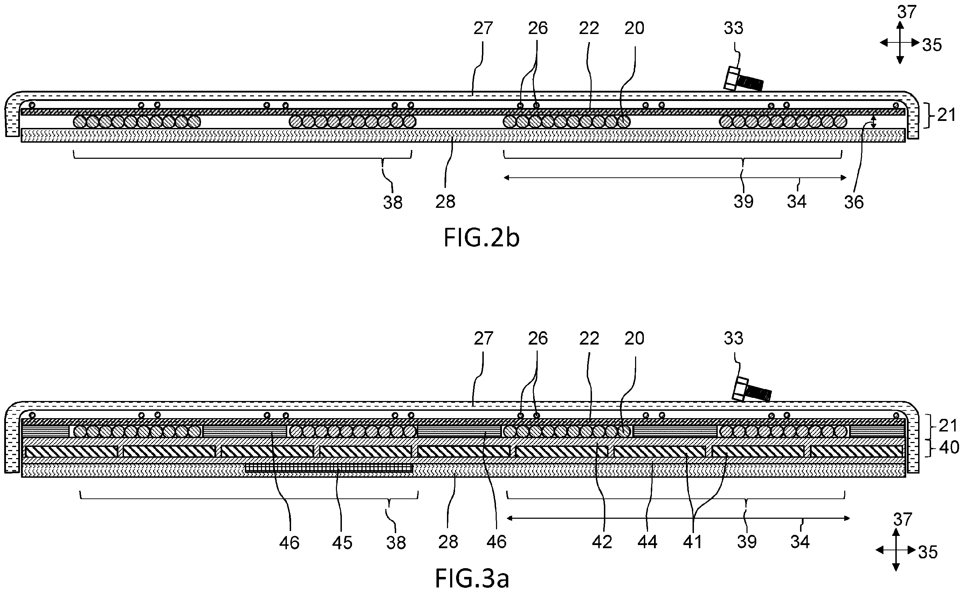

Figure 2a shows a schematic exploded and perspective view of an example embodiment of the wireless power transfer pad 1, and figure 2b shows a schematic cross-section of such a wireless power transfer pad 1 in an assembled state. As mentioned above, the wireless power transfer pad 1 comprises an oscillating electromagnetic field generating device 20 configured for transmitting energy to the wireless power receiver 4 associated with the vehicle 2, as well as a solar panel arrangement 21, which includes a photovoltaic substrate 22 with a front side 23 and a rear side 24, a front side electrode arrangement and a rear side electrode arrangement. The wireless power transfer pad 1 further comprises a foreign object detection arrangement 25 including a plurality of foreign object detection coils 26.

Since wireless energy transmission via an oscillating electromagnetic field from a transmitting induction coil to a receiver coil may be transformed into thermal energy within metallic foreign objects being located near the oscillating electromagnetic field, such as on the wireless power transfer pad 1, it is beneficial from a safety and fire perspective to provide a foreign object detection arrangement 25 that is configured to detect foreign metal objects being located on the wireless power transfer pad 1 before initiating high-power wireless power transfer.

A foreign metal object may for example be any type of loose metal object that may, accidentally or for any other reason, have ended up on the pad 1, such as a metal fastener 33 as illustrated in figure 2b, a metal coin, a metal can or container, a metal sheet or disc, or the like.

In the example embodiment of figure 2a and 2b, the foreign object detection arrangement 25 includes an array of foreign object detection coils 26 distributed over a top area of the wireless power transfer pad 1, in particular over a large portion of the top area of said pad 1.

The foreign object detection arrangement may for example include an array of at least 4, specifically at least 12, and more specifically at least 20 individual foreign object detection coils distributed over a top area of the wireless power transfer pad.

Moreover, the foreign object detection coils 26 are configured to function also as the front side electrode arrangement of the solar panel arrangement 21. In other words, the foreign object detection coils 26 have a dual functionality in that they function both as foreign object detection coils 26 and front side electrode arrangement of the solar panel arrangement 21, although not at the same time.

Consequently, the solar panel arrangement 21 enables the wireless power transfer pad 1 to not only contribute to wireless charging of the ESS 3 of the vehicle 2 when a vehicle is located above the wireless power transfer pad 1, but also to generate electrical energy when no vehicle is located above the wireless power transfer pad 1, i.e. when the wireless power transfer pad 1 is exposed to sunlight.

The use of the foreign object detection coils 26 as front side electrode arrangement of the solar panel arrangement 21 is particularly relevant and efficient when the foreign object detection coils 26 are evenly distributed and having a form and/or size that results in a relatively dense distribution of wires functioning as front side electrodes, because thereby free electrons may more easily move from the location in the photovoltaic substrate 22 to the wires of the foreign object detection coils 26, or oppositely. However, too dense distribution of wires functioning as front side electrodes is not desired because it will shield the front side 23 of the photovoltaic substrate 22 from receiving sunlight.

With reference again to figure 2a and 2b, the wireless power transfer pad 1 may further comprise a front side cover 27 and a rear side cover 28 for encapsulating and protecting the oscillating electromagnetic field generating device 20, the foreign object detection arrangement 25, and the photovoltaic substrate 22.

The front side cover 27 must be transparent and penetrable for solar radiation for enabling sun light to reach the photovoltaic substrate 22. The front side cover 27 may thus for example be made of transparent plastic material or glass or the like. The rear side cover may for example be made of plastic material, a metal material, such as aluminium, or the like.

Additional intermediate layers, such as one or more encapsulating layers made of for example transparent ethylene vinyl acetate may be provided between the solar panel arrangement 21 and the front side cover 27 and rear side cover 28, respectively, for improved protection of the solar panel arrangement 21 against moisture, vibrations, etc.

The photovoltaic substrate 22 may for example be a conventional mono-crystalline and multi-crystalline silicon wafer having a positive doped (p-doped) layer and negative doped (n-doped) layer. For example, a front side layer 30 of the photovoltaic substrate 22 may be p-doped and a rear side layer 31 of the photovoltaic substrate may be n-doped. Alternatively, the front side layer 30 of the photovoltaic substrate 22 may be n-doped and the rear side layer 31 of the photovoltaic substrate 22 may be p-doped.

In other words, the photovoltaic substrate 22 may for example be of the type largearea p-n junction made from silicon. However, the photovoltaic substrate 22 may alternatively be organic solar cell type, dye sensitized solar cell type, perovskite solar cell type, quantum dot solar cell type, or the like.

The surface of the photovoltaic substrate 22 may be textured for improved lighttrapping efficiency.

The uneven distribution of negatively charged electrons and positively charged "holes" in the photovoltaic substrate 22 caused by incident light rays generates a voltage potential between the front and rear side layers 30, 31, which voltage potential may be utilised in an electric circuit by connecting electrically conducting electrodes to the surface of the front and rear side layers 30, 31. In other words, the photovoltaic substrate 22 includes a front side electrode arrangement being in contact with a surface of the front side 23 of the photovoltaic substrate 22, and a rear side electrode arrangement being in contact with a surface of the rear side 24 of the photovoltaic substrate 22.

The front side electrode arrangement is thus configured for enabling a flow of electrons between the front side 23 of the photovoltaic substrate 22 and the front side electrode arrangement, and the rear side electrode arrangement is configured for enabling a flow of electrons between the rear side 24 of the photovoltaic substrate 22 and the rear side electrode arrangement.

The front and rear side electrode arrangements may then be used as electrical terminals of the photovoltaic substrate 22 when the photovoltaic substrate 22 is operating as an electrical power source in form of a photovoltaic solar panel.

The oscillating electromagnetic field generating device 20 includes at least one coil. The coil is made of a conductive wire, such as a round or rectangular wire that is wound into a spiral planar coil.

In the example embodiment illustrated of figure 2a and 2b, the oscillating electromagnetic field generating device 20 is configured to function also as the rear side electrode arrangement. Thereby, also the oscillating electromagnetic field generating device 20 has a dual functionality in that it is partly configured to generate the desired high-power oscillating electromagnetic field during wireless power transfer from the wireless power transfer pad 1 to the wireless power receiver 4 associated with the vehicle 2 during charging of the ESS 3 of the vehicle is located above the wireless power transfer pad 1, and partly configured to act as conductor for electrons entering or exiting the rear side 24 of the photovoltaic substrate 22 when the wireless power transfer pad 1 is exposed to sunlight.

It is from a photovoltaic solar panel perspective efficiency generally desirable that the oscillating electromagnetic field generating device 20 has a large and well distributed surface area in contact with the rear side 24 of the photovoltaic substrate 22 for enabling smooth electron passage between the oscillating electromagnetic field generating device 20 and the rear side 24 of the photovoltaic substrate 22 over a large surface area thereof, because this results in increased efficiency and power output of the photovoltaic solar panel arrangement 21.

Therefore, the oscillating electromagnetic field generating device 20 may be implemented in form a planar coil, for example with a double-D configuration as illustrated in figure 2a and 2b, wherein the double-D configuration includes a first essentially rectangular planar coil 38 and a second essentially rectangular planar coil 39 arranged side-by-side. The double-D configuration is however merely one example, and the coil may alternatively have a single-D configuration, or circular, or the like.

As shown in figure 2b, the planar configuration of the coil is defined in that the coil has a width to vertical ratio of at least 5, specifically at least 10, meaning that an outer width 34 of the coil in a horizontal direction 35 is at least 5 times, specifically at least 10 times, larger than an outer height 36 of the coil in a vertical direction 37.

Each of the foreign object detection coils 26 is schematically depicted as being made of a single loop of a single wire, but each coil may in fact consist of a plurality of loops made of a multi-wire lead. Similarly, each of the first and second induction coils 38, 39 is schematically depicted as being made of a single spiral layer of a single wire, but each induction coil may in fact consist of a plurality of layers made of a multi-wire lead.

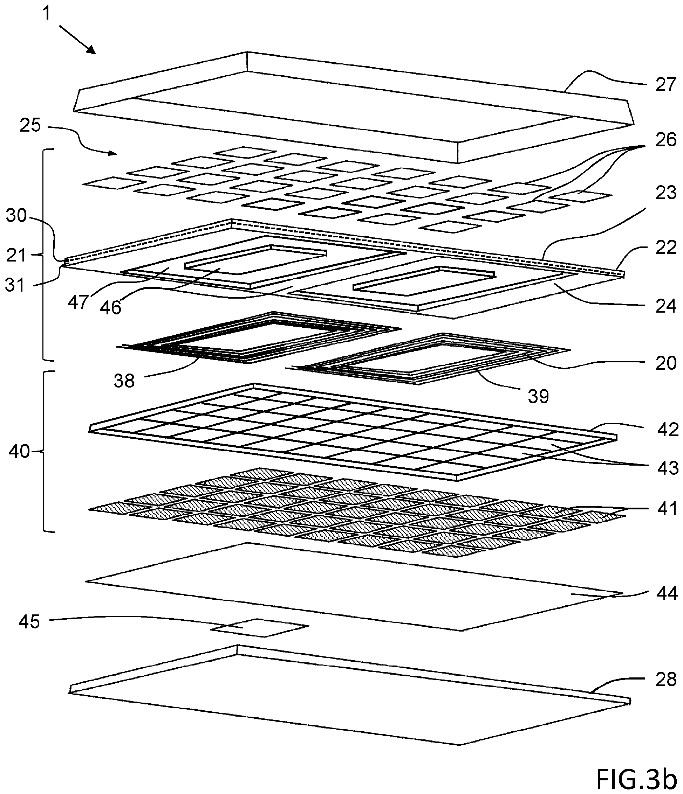

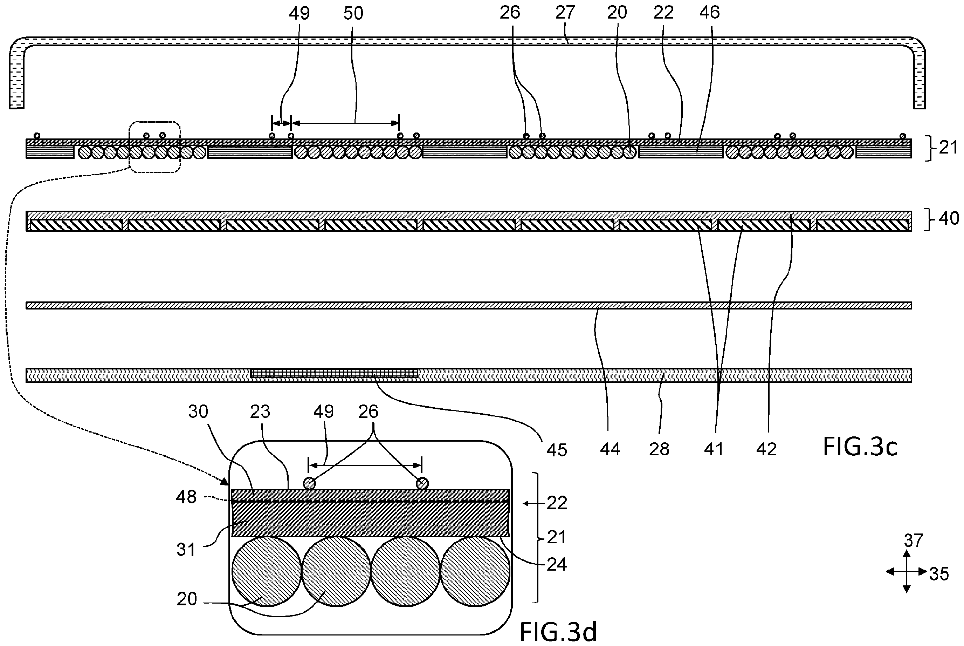

Figure 3a shows a schematic cross-section of a further example embodiment of the wireless power transfer pad 1 in an assembled state, figure 3b shows a schematic exploded and perspective view of the same wireless power transfer pad 1, figure 3c shows a schematic exploded cross-sectional side view of the same wireless power transfer pad 1 and figure 3d shows an enlargement of the region within the dashedline rectangle of figure 3c.

This example embodiment of the wireless power transfer pad 1 includes a magnetic shield layer 40 installed beneath and in the vicinity of the induction coil 20 and is configured for providing a path for the magnetic flux emitted downwards from the induction coil 20, thereby providing improved power-supplying efficiency of the wireless power transfer pad 1. The magnetic shield may for example include highly permeable ferromagnetic core material, such as ferrite, positioned below the induction coil 20 for providing a path of low magnetic reluctance for the flux with minimized field leakages and hence improved coupling with the wireless power receiver 4.

Due to the brittle character of ferrite material, the ferrite layer may for example be provided in form of rectangular ferrite tiles 41 that are assembled into a generally plate-like structure for providing the desired power transfer flux path. The ferrite tiles 41 may for example be mounted in appropriate slots 43 provided in a plate-formed holding structure 42, such as sheet, made of plastic or metal material.

The example embodiment of the wireless power transfer pad 1 of figures 3a-3d may further comprise a reinforcement layer 44 located for example next to the rear side cover 28 for providing improved structural strength to the pad 1, especially when the rear side cover 28 itself does not have any significant structural strength. The reinforcement layer 44 may for made of metal, such as aluminium or steel, or the like.

The wireless power transfer pack 1 may also, depending on the level of system integration in the wireless power transfer pack 1, include one or more electronic components and/or printed circuit boards 45 with appropriate electronic components, for providing desired functionality, such as vehicle positioning system, vehicle communication system, foreign object detection circuits, etc. Moreover, in certain embodiments, also the electronic units of the power supply device 6 described with reference to figure 1 may be integrated into the pad 1 in form of electronic units, printed circuit boards, etc.

In the example embodiment of figures 3a-3d, the rear side of the photovoltaic substrate 22 further has a projected surface structure 46 serving as holder or support for the coil(s) of the oscillating electromagnetic field generating device 20. The projected surface structure 46, which define recesses 47 between neighbouring projected areas, provide horizontal support for the induction coils. Thereby, the coil(s) of the oscillating electromagnetic field generating device 20 may be more easily assembled on the photovoltaic substrate 2, and the risk for undesired displacement of one or more wires of the coil is reduced.

As illustrated in figure 3c, the projected surface structure 46 is separate parts that are attached to the rear side of the substrate 22, i.e. a non-integral projected surface structure 46. However, the projected surface structure 46 may alternatively be formed direct in the substrate 22, i.e. an integral projected surface structure 46.

Figure 3d shows a schematic, magnified, cross-sectional view of a portion of the photovoltaic solar panel arrangement 21. As described above, the photovoltaic substrate 22 has a front side 23 configured to face vertically upwards and a rear side 24 configured to face vertically downwards, when the wireless power transfer pad 1 is placed flat on a horizontal surface and with the front side cover 27 facing upwards.

The photovoltaic substrate 22 further has the doped front and rear side layers 30, 31, as well as a p-n junction 48 located in an intermediate region between said front and rear side layers 30, 31.

The front side electrode arrangement of the photovoltaic solar panel arrangement 21 is provided in form of the foreign object detection coils 26, which are assembled in electrical contact with the front side 23 of the substrate 22. The smallest distance 49 between wires of neighbouring coils may be set relatively small for ensuring that no object may remain undetected due to being located between neighbouring detection coils 26, such as for example 1 - 10 mm.

The maximal interior distance 50 of a detection coil may be set for enabling acceptable resistance against flow of electrons between the front side of the photovoltaic substrate and the detection coils when functioning as front side electrode arrangement. A small maximal interior distance 50 results in reduced resistance against flow of electrons between the front side of the photovoltaic substrate and the detection coils, but also increased shielding effect on sunlight reaching the substrate 22. The maximal interior distance 50 may for example be set to about 20 - 250 mm.

The rear side electrode arrangement is provided in form of the induction coil of the oscillating electromagnetic field generating device 20, which induction coil this is arranged in electrical contact with the rear side 24 of the substrate 22.

In the schematic figure 3d, each foreign object detection coil 26 is illustrated as being made of a solid single wire conductor, but each foreign object detection coil 26 may alternatively be composed of multiple loops, i.e. multiple windings, having for example about 2 - 10 laps, and the conductor as such may be a multi-wire conductor. Moreover, each foreign object detection coil 26 may for example have a flat shape with spiral wound conductor for increasing the electrical contact area with the front side 23 of the substrate 22.

Similarly, the conductor of each induction coil 20 is illustrated as being made of a solid circular single wire conductor, but the conductor of the induction 20 may alternatively have a different cross-sectional shape and/or being composed of multi-wire conductor for increasing the electrical contact area with the rear side 24 of the substrate 22.

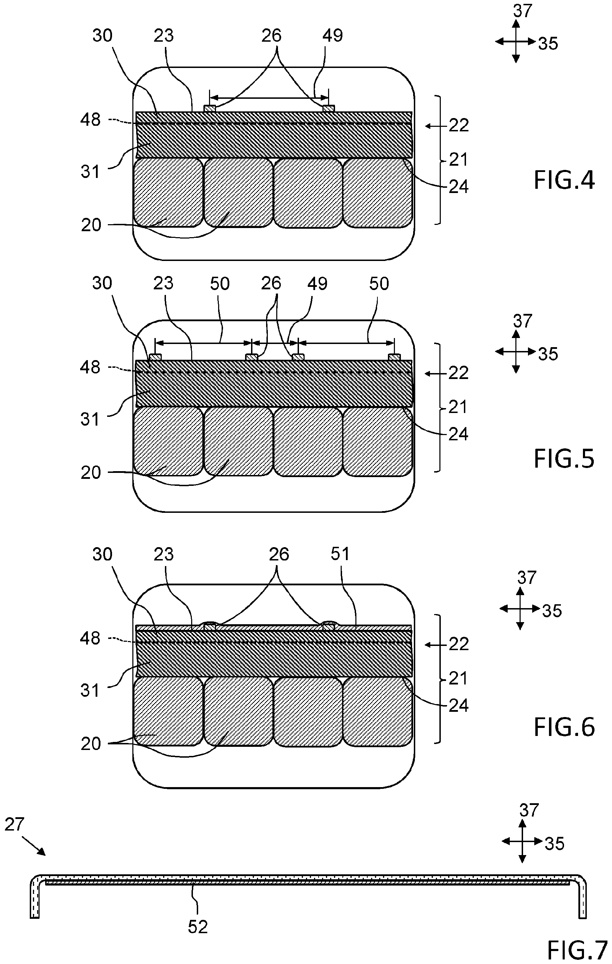

For example, as schematically illustrated in figure 4, the conductor of the induction 20 may have a rectangular cross-sectional shape for increasing the electrical contact area with the rear side 24 of the substrate 22.

Moreover, as schematically illustrated in figure 5, the number and density of the foreign object detection coils 26 may be altered and selected taking into account the special circumstances of each individual implementation. In the example embodiment of figure 5, both the smallest distance 49 between wires of neighbouring coils, and the maximal interior distance 50 of each detection coil 26, are smaller compared with the example embodiment of figure 4.

In figure 6, the wireless power transmission pad 1 according to a further example embodiment comprises an anti-reflection layer 51 provided on front side of photovoltaic substrate 22, for the purpose of reducing the amount of sun rays reflecting on the upper surface of the substrate 22. The anti-reflection layer 51 thus increases the amount the amount of sunlight reaching the substrate 22. The anti-reflection layer 51 may for example be made of a thin layer of titanium dioxide, or the like.

Alternatively, or on combination with above, the wireless power transmission pad 1 may according to a further example embodiment comprise an anti-reflection layer 52 provided on the front cover 27, such as for example on the interior surface of the front cover 27, as schematically illustrated in figure 7.

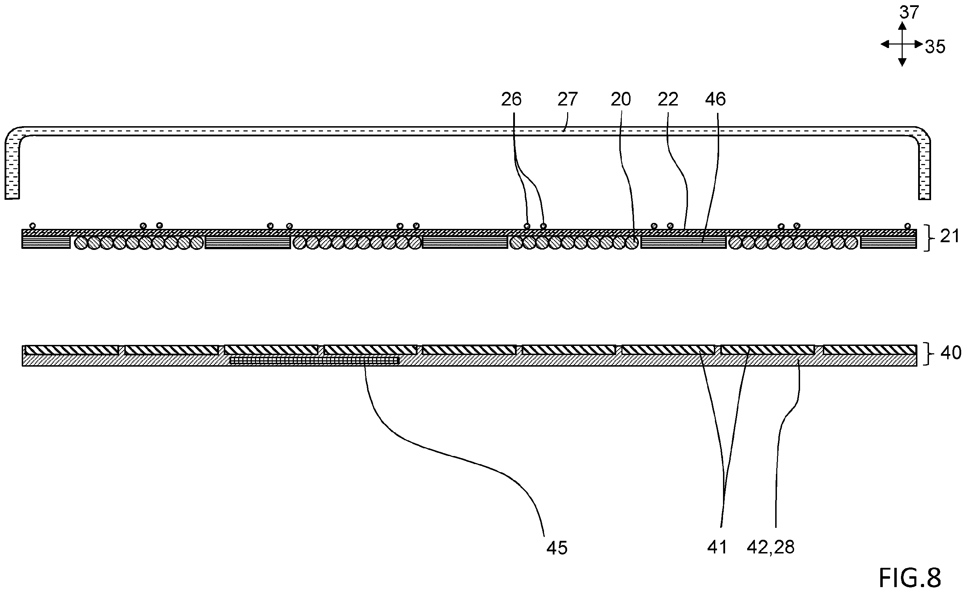

Figure 8 schematically shows still a further example embodiment of the wireless power transfer pad 1, in which the magnetic shield layer 40 including its plate-formed holding structure 42 and the associated ferrite tiles 41, is integrated with a rigid rear side cover 28, thereby eliminating the need for a separate reinforcement layer 44 and a separate rear side cover 28. Many more alternative example embodiments of the layout of the wireless power transfer pad 1 is possible within the scope of the appended claims.

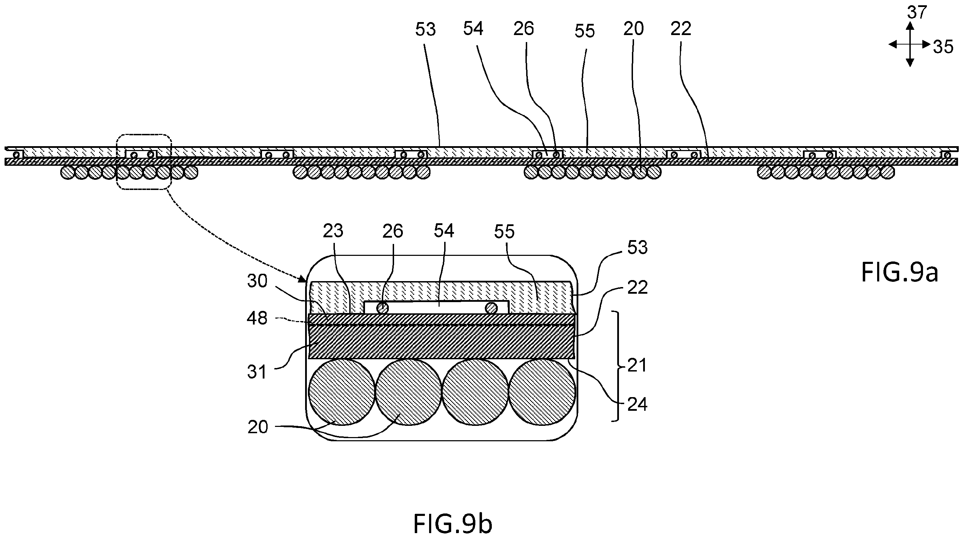

Figures 9a and 9b shows another aspect of the wireless power transfer pad 1, wherein the photovoltaic substrate 22 may have projected and/or recessed surface structure 53 serving as holder for the foreign object detection coils 26. Thereby, the assembly, positioning and securement of the detection coils 26 on the front side 23 of the photovoltaic substrate 22 is simplified and improved. The projected and/or recessed surface structure 53 may for example include cavities 54 arranged between neighbouring protrusions 55, which cavities form spaces for the wires of the detection coils 26. Such projected and/or recessed surface structure 53 is preferable be transparent for enabling sunlight to reach the underlying substrate 22. Moreover, the projected and/or recessed surface structure 53 may be integral or non-integral with the photovoltaic substrate 22.

Alternatively, or in combination with above, the wires of the detection coils 26 may be fastened to the front side 23 of the photovoltaic substrate 22 by adhesive, sewing, or the like. Still more alternatively, the wires of the detection coils 26 may be formed by metal printing or depositing on the surface of the front side 23 of the photovoltaic substrate 22, or the like.

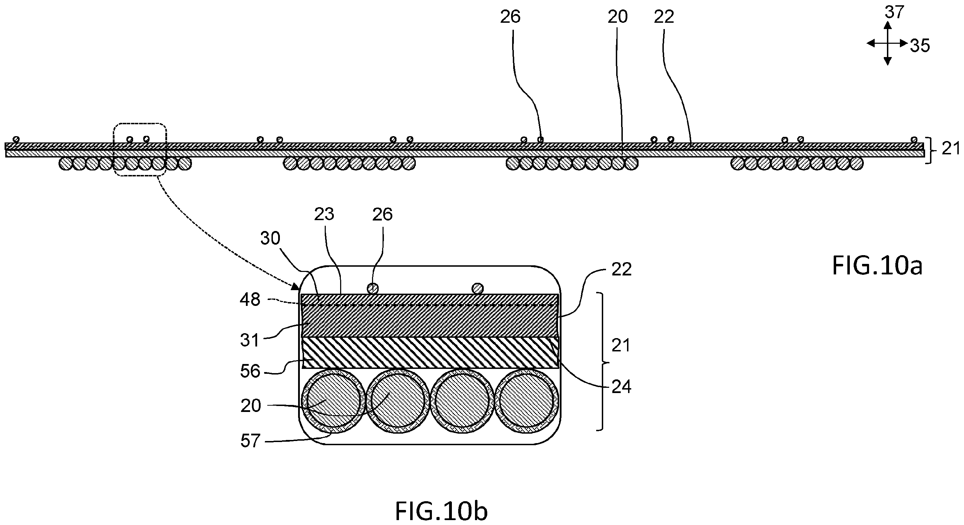

According to still a further example embodiment described with reference to figure 10a and 10b, the wireless power transfer pad 1 may include an electrically conductive sheet 56 configured for serving as the rear side electrode arrangement. Consequently, the electrically conductive sheet 56 is preferably in electrical contact with surface of the rear side 24 of the photovoltaic substrate 22.

In particular, the electrically conductive sheet 56 is preferably arranged between the photovoltaic substrate 22 and the coils forming the oscillating electromagnetic field generating device 20.

The electrically conductive sheet 56 may for example be an aluminium sheet, or the like. Moreover, the electrically conductive sheet 56 may be deposited, printed or otherwise formed on the surface of the rear side 24. Still more alternatively, the electrically conductive sheet 56 may be a separate sheet that is attached to the surface of the rear side 24. The electrically conductive sheet 56 enables increased surface contact area with the rear side 24 of the substrate 22, such that energy generation efficiency of the photovoltaic substrate 22 may be obtained.

This scenario also enable use of more conventional HF-Litz wires for making the induction coils 20. Due to aspects such as winding losses and eddy current losses, massive single conductors with a large cross-sectional area may be deemed impractical for manufacturing of induction coils for inductive charging pads with frequencies in the kHz-range. Therefore, coil wires made of multiple thin individually insulated wire strands through which the AC current can travel with reduced conductor diameter d, called HF-Litz wires may be used. These bundles may then have a common external electrical insulation layer 57.

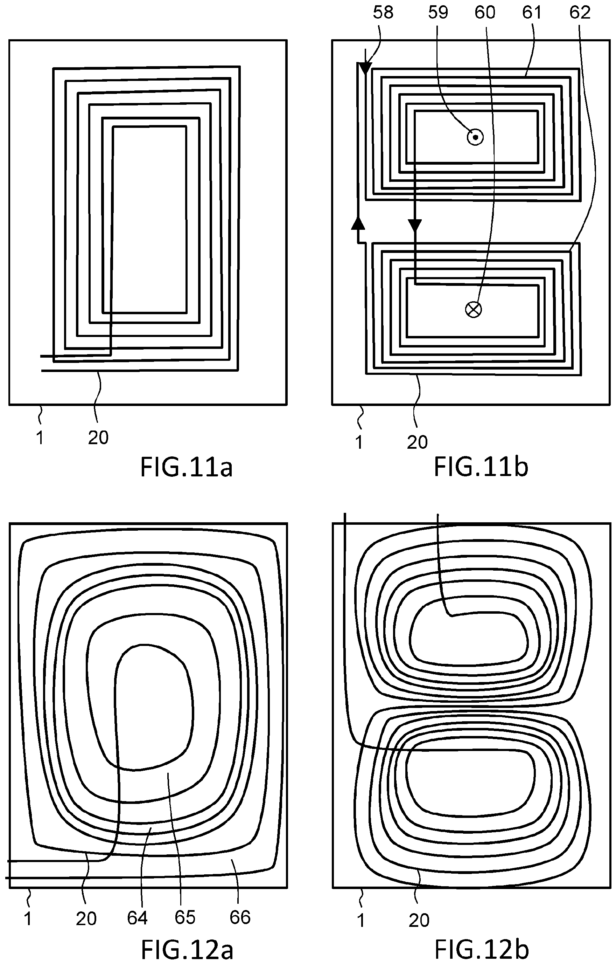

Figure 11a shows a top view of an example embodiment of the induction coil functioning as combined oscillating electromagnetic field generating device 20 and rear side electrode arrangement for the photovoltaic substrate 22. The induction coil is formed as planar rectangular coil having a plurality of windings. The induction coil 20 may have a single layer of wires, or a plurality of layers of windings, as seen in the vertical direction when the pad 1 is resting flat on the ground. The wire of the induction coil 20 may be spread out over the surface of the pad 1 for increasing the surface coverage of the induction coil 20 in an effort to improve its efficiency as rear side electrode arrangement for the photovoltaic substrate 22.

Figure 11b shows an alternative example embodiment, wherein the induction coil 20 has a double-D configuration. In other words, the induction coil includes two coils arranged side-by-side and with opposite winding direction, such that an AC routed through the wire of the double-D induction coils 20 generates changing magnetic field stretching between the individual coils of the double-D induction coils 20.

For example, during the time period with current flow in a first direction, as illustrated by 58, the upper coil 61 in figure 11b will generate a magnetic field projecting outwards from the surface, as illustrated by 59, and the lower coil 62 in figure 11b will generate a magnetic field projecting inwards from the surface, as illustrated by 60, wherein the outwards and inwards projecting magnetic fields will jointly form a single magnetic flux.

Figure 12a and 12b an alternative layout of the single configuration induction coil and double-D configuration induction coil as described with reference to figures 11a and 11b, but here with a more spread out layout for providing further increased surface coverage of the induction coil 20 in an effort to improve its efficiency as rear side electrode arrangement for the photovoltaic substrate 22.

Moreover, with reference to figure 12a, the density of the wires of the induction coil 20, i.e. the number of wire per substrate surface area, may be larger in a central area 64 along the winding of the coil, and smaller in the inner periphery 65 and outer periphery 66 of the winding of the coil.

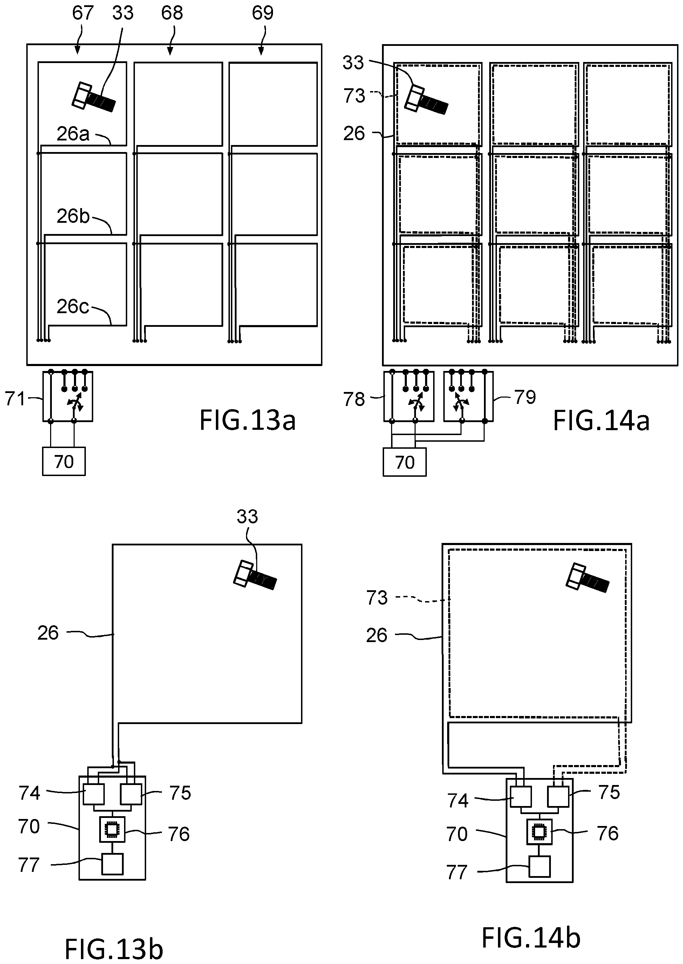

Figure 13a shows schematically a top view of an example embodiment of an array of square-shaped foreign object detection coils 26. In this simplified example, nine detection coils 26 are included, divided into three columns 67, 68, 69. In this specific example, one wire of each coil of a first column may be connected to a common lead, and the other wire of each coil of said first column may have individual leads. Thereby, a foreign object detection circuit 70 may be selectively connected to each individual detection coil 26a, 26b, 26 of the first column 67, for example via a multiplexer 71. The same arrangement may apply for each column 67-69 of coils 26. Thereby, the foreign object detection circuit 70 may detect whether a foreign metal object 33 is located on the pad 1 and also where on the pad 1 the foreign metal object 33 is located. In response thereto, the wireless power transmission pad 1 may be controlled to take appropriate action, such as informing the driver about the object 33, and/or initiate wireless charging with reduced power level, and/or with special setting, or the like.

Alternatively, the foreign object detection coils 26 may be more rudimentary connected with the foreign object detection circuit 70, without multiplexer 71 and without possibility to detect location of the foreign metal object 33, thereby merely enabling detection of existence of a foreign metal object 33 somewhere on the pad 1.

The detection coils 26 may rely on field-based detection via inductive coupling between a detection coil 26 and a metal foreign object 33, wherein the inductance and the quality factor of the detection coil change with an adjacent metal foreign object 33.

Figure 13b shows an example of a foreign object detection circuit 70 connected to a single detection coil 26. The foreign object detection circuit 70 may include a signal generator and transmitter 74, a signal receiver, 75, a data processing unit 76 and a data memory 77 for storing instructions etc. A foreign metal object 33 may be detected by detecting variation in inductance, wherein an equivalent resistance of the detection coil changes with the presence of a foreign metal object 33. Specifically, for a transmitted pulse excitation in the detection coil 26 by the foreign object detection circuit 70, the subsequent response is registered by the foreign object detection circuit 70. An analysis of the response, for example by counting the number of pulses or measuring the amplitude of the response, may then be used to detect presence of a foreign metal object on the pad 1.

Alternatively, the induction coil 20 may be used for generating a low power oscillating magnetic field, and the foreign object detection circuit 70 may then detect the level voltage induced in the detection coil 26, wherein a foreign metal object located on the pad 1 will affect the level of induced voltage, thereby enabling detecting of a foreign metal object by the foreign object detection circuit 70.

A further detection approach is hereinafter described with reference to figure 14a, wherein an extra coil set is introduced to generate the magnetic field for the induced voltage. In other words, the extra coils 73, marked with dashed lines in figure 13b, acts as source coils for generating the oscillating magnetic field that induces a voltage in the detection coils 26, thereby enabling detection of a foreign metal object without use of the induction coil 20.

In other words, each coil set of the foreign object detection arrangement includes a transmitter coil 73 (indicated with dashed lines) and a detector coil 26 (indicated with solid lines). Detection is performed by applying an AC in a selected transmitter coil 73 for generating an oscillating magnetic field. The foreign object detection circuit 70 may then detect whether any voltage is induced in the detection coil 26, wherein a foreign metal object located on the pad 1 will effect to level of induced voltage, thereby enabling detecting of a foreign metal object by the foreign object detection circuit 70.

A foreign object detection circuit 70 may be selectively connected to each individual detection coil 26 and associated transmitter coil 73, for example via a first and second multiplexers 78, 79. The same arrangement may apply for each column of the array of coils 26. Thereby, the foreign object detection circuit 70 may detect whether a foreign metal object 33 is located on the pad 1 and also where on the pad 1 the foreign metal object 33 is located. In response thereto, the wireless power transmission pad 1 may be controlled to take appropriate action, such as informing the driver about the object 33, and/or initiate wireless charging with reduced power level, and/or with special setting, or the like.

Alternatively, the foreign object detection coils 26 and transmitter coils 73 may be more rudimentary connected with the foreign object detection circuit 70, without first and/or second multiplexers 71 and without possibility to detect location of the foreign metal object 33, thereby merely enabling detection of occurrence of a foreign metal object 33 somewhere on the pad 1.

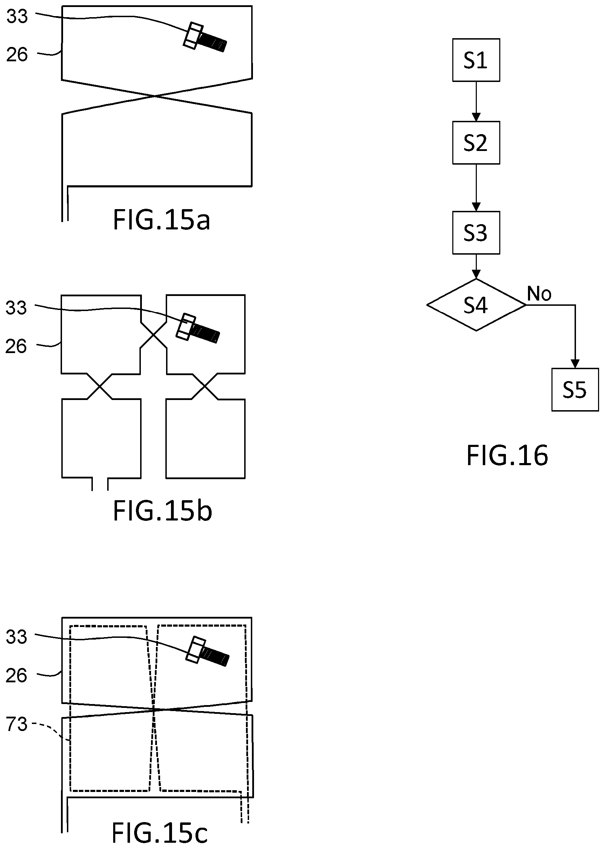

Many other forms, designs, sizes and shapes of the detection coils 26 and/or transmitter coils 73 are possible. For example, with reference to figure 15a, the detector coil 2 may be a double-D bipolar coil, such that any induced voltage by inductor coil 20 or a transmitted coil 73 (not showed) will be cancelled out due to the bipolar configuration, unless there is a disturbing adjacent foreign metal object 33. Another possible configuration of the detector coil 2 is quadruple-D bipolar coil, as shown in figure 15b. Both these configurations of the detector coil provide good distribution of the wires of the coil over the surface of the pad 1, for the purpose of enabling high efficiency electron transfer rate from substrate 22 to electrode.

With respect to the foreign object detection arrangement including a plurality of coil sets, each having both transmitter coil 73 and a detector coil 26, then each coil set may include two perpendicular bipolar coils as transmitter coil 73 and detector coil 26, as shown in figure 15c. Also this arrangement provides good distribution of the wires of the coil over the surface of the pad 1, for the purpose of enabling high efficiency electron transfer rate from substrate 22 to electrode.

The disclosure also relates to a method for wireless charging of an electrical storage system of a hybrid electric or electric vehicle. The basic steps of the method is described below with reference to figure 16. The method comprises a first step S1 of supplying electrical power generated by a solar panel arrangement 21 integrated in a stationary wireless power transfer pad 1 to an electrical grid 7 or a local stationary electrical storage system 15, wherein the solar panel arrangement 21 includes a photovoltaic substrate 22 with a front side 23 and a rear side 24, a front side electrode arrangement and a rear side electrode arrangement.

The method further comprises a second step S2 of positioning the hybrid electric or electric vehicle over the wireless power transfer pad 1, such that the wireless power transfer pad 1 is arranged adjacent a wireless power receiver 4 associated with the vehicle 2. For example, the vehicle may be positioned such that the wireless power transfer pad 1 at partly, or even substantially, overlaps with the wireless power receiver 4, as seen in the vertical direction.

The method additionally comprises a third step S3 of detecting, by means of a foreign object detection arrangement 25 integrated in the wireless power transfer pad 1, any metal foreign object 33 located on the wireless power transfer pad 1, wherein the foreign object detection arrangement 25 includes a plurality of foreign object detection coils 26, which are configured to function also as said front side electrode arrangement.

The method further comprises a fourth step S4 of checking if any foreign object is detected on the pad 1, and if no foreign object is detected, a fifth step S5 involves initiating charging of the electrical storage system of the hybrid electric or electric vehicle with electrical energy from the electrical grid or the local stationary electrical storage system by generating an oscillating electromagnetic field generating in the wireless power transfer pad and thereby inducing an electrical current in the wireless power receiver.

Detection of a foreign metal object may for example include evaluating a registered pulse response amplitude, frequency or level of induced voltage in the detection coil, and comparing this value with a threshold value of range of vales, and finally to conclude occurrence of a foreign metal object if the pulse response amplitude, frequency or level of induced voltage in the detection coil is outside an expected range corresponding to a pad free from foreign metal objects.

It will be appreciated that the above description is merely exemplary in nature and is not intended to limit the present disclosure, its application or uses. While specific examples have been described in the specification and illustrated in the drawings, it will be understood by those of ordinary skill in the art that various changes may be made and equivalents may be substituted for elements thereof without departing from the scope of the present disclosure as defined in the claims.

Moreover, the various features, functions and aspects described herein with reference to specific example embodiments are not limited to said specific embodiment, but may be implemented together with other features, functions and aspects described with reference to another figure of the disclosure. For example, the various different designs and embodiments of the foreign object detection arrangement descried with references to figures 13a - 15c and/or the induction coil arrangement descried with references to figures 11a - 12b may be combined in various combinations and also together with the wireless power transmission pad 1 descried with references to figures 1 - 10b. Similarly, the metal layer 56 as rear electrode descried with references to figures 9a - 9b may be combined with the various designs of the wireless power transmission board 1 descried with references to figures 1 - 8, and so on.

Furthermore, modifications may be made to adapt a particular situation or material to the teachings of the present disclosure without departing from the essential scope thereof.

Therefore, it is intended that the present disclosure not be limited to the particular examples illustrated by the drawings and described in the specification as the best mode presently contemplated for carrying out the teachings of the present disclosure, but that the scope of the present disclosure will include any embodiments falling within the foregoing description and the appended claims. Reference signs mentioned in the claims should not be seen as limiting the extent of the matter protected by the claims, and their sole function is to make claims easier to understand.

## Claims

1. A wireless power transfer pad (1) for wireless charging of a vehicle electrical storage system, the wireless power transfer pad (1) comprising:
an oscillating electromagnetic field generating device (20) configured for transmitting energy to a wireless power receiver (4) associated with the vehicle,
a foreign object detection arrangement (25) including a plurality of foreign object detection coils (26), and
a solar panel arrangement (21) including a photovoltaic substrate (22) with a front side (23) and a rear side (24), a front side electrode arrangement and a rear side electrode arrangement,
wherein the foreign object detection coils (26) are configured to function also as the front side electrode arrangement.

2. The wireless power transfer pad (1) according to claim 1, wherein the oscillating electromagnetic field generating device (20) includes at least one coil (38, 39).

3. The wireless power transfer pad (1) according to any of claims 1-2, wherein the oscillating electromagnetic field generating device (20) is configured to function also as the rear side electrode arrangement.

4. The wireless power transfer pad (1) according to any of claims 1 - 2, further comprising an electrically conductive sheet (56) configured for serving as the rear side electrode arrangement.

5. The wireless power transfer pad (1) according to claim 4, wherein the electrically conductive sheet (56) is arranged between the photovoltaic substrate (22) and the oscillating electromagnetic field generating device (20).

6. The wireless power transfer pad (1) according to any of claims 1 - 5, further comprising an anti-reflection layer (51) provided on front side (23) of photovoltaic substrate (22).

7. The wireless power transfer pad (1) according to any of claims 1 - 6, further comprising a front side cover (27) and a rear side cover (28) for encapsulating and protecting the oscillating electromagnetic field generating device (20), the foreign object detection arrangement (25) and the photovoltaic substrate (22).

8. The wireless power transfer pad (1) according to claim 7, further comprising an anti-reflection layer (52) provided on the front cover (27).

9. The wireless power transfer pad (1) according to any of claims 7-8, wherein the front cover (27) is transparent and penetrable for solar radiation.

10. The wireless power transfer pad (1) according to any of claims 1-9, wherein the photovoltaic substrate (22) has a projected and/or recessed surface structure (46, 53) serving as holder for the foreign object detection coils (26) and/or a coil of the oscillating electromagnetic field generating device (20).

11. The wireless power transfer pad (1) according to any of claims 1 - 10, wherein the front side electrode arrangement is configured for enabling a flow of electrons between the front side (23) of the photovoltaic substrate (22) and the front side electrode arrangement, and wherein the rear side electrode arrangement is configured for enabling a flow of electrons between the rear side (24) of the photovoltaic substrate (22) and the rear side electrode arrangement.

12. The wireless power transfer pad (1) according to any of claims 1 - 11, wherein a front side layer (30) of the photovoltaic substrate (22) is p-doped and a rear side layer (31) of the photovoltaic substrate (22) is n-doped, or wherein a front side layer (30) of the photovoltaic substrate (22) is n-doped and a rear side layer (31) of the photovoltaic substrate (22) is p-doped.

13. The wireless power transfer pad (1) according to any of claims 1 - 12, wherein the foreign object detection arrangement (25) includes an array of at least 4, specifically at least 12, and more specifically at least 20 individual foreign object detection coils (26) distributed over a top area of the wireless power transfer pad (1).

14. A system comprising a wireless power transfer pad (1) according to any of the preceding claims, and a hybrid electric or electric vehicle with an electrical storage system and a wireless power receiver (4), wherein an oscillating electromagnetic field generating device (20) of the wireless power transfer pad (1) is configured for transmitting energy to the wireless power receiver (4) of the vehicle.

15. A method for wireless charging of an electrical storage system of a hybrid electric or electric vehicle comprising:
supplying electrical power generated by a solar panel arrangement (21) integrated in a stationary wireless power transfer pad (1) to an electrical grid (7) or a local stationary electrical storage system (15), wherein the solar panel arrangement (21) includes a photovoltaic substrate (22) with a front side (23) and a rear side (24), a front side electrode arrangement and a rear side electrode arrangement,
positioning the hybrid electric or electric vehicle over the wireless power transfer pad (1), such that the wireless power transfer pad (1) is arranged adjacent a wireless power receiver (4) associated with the vehicle,
detecting, by means of a foreign object detection arrangement (25) integrated in the wireless power transfer pad (1), any foreign object located on the wireless power transfer pad (1), wherein the foreign object detection arrangement (25) includes a plurality of foreign object detection coils (26), which are configured to function also as said front side electrode arrangement,
if no foreign object is detected, initiating charging of the electrical storage system (3) of the hybrid electric or electric vehicle with electrical energy from the electrical grid (7) or the local stationary electrical storage system (15) by generating an oscillating electromagnetic field generating in the wireless power transfer pad (1) and thereby inducing an electrical current in the wireless power receiver (4).

## Patentansprüche

1. Drahtloses Leistungsübertragungspad (1) zum drahtlosen Laden eines elektrischen Fahrzeugspeichersystems, das drahtlose Leistungsübertragungspad (1) umfassend:
eine Vorrichtung (20) zum Erzeugen eines oszillierenden elektromagnetischen Felds, die zum Übertragen von Energie an einen drahtlosen Leistungsempfänger (4) konfiguriert ist, der dem Fahrzeug zugeordnet ist,
eine Fremdkörpererfassungsanordnung (25), die eine Vielzahl von Fremdkörpererfassungsspulen (26) einschließt, und
eine Solarplattenanordnung (21), die ein Photovoltaiksubstrat (22) mit einer Vorderseite (23) und einer Rückseite (24), eine vorderseitige Elektrodenanordnung und eine rückseitige Elektrodenanordnung einschließt,
wobei die Fremdkörpererfassungsspulen (26) konfiguriert sind, um ebenso als die vorderseitige Elektrodenanordnung zu fungieren.

2. Drahtloses Leistungsübertragungspad (1) nach Anspruch 1, wobei die Vorrichtung (20) zum Erzeugen eines oszillierenden elektromagnetischen Felds mindestens eine Spule (38, 39) einschließt.

3. Drahtloses Leistungsübertragungspad (1) nach einem der Ansprüche 1 bis 2, wobei die Vorrichtung (20) zum Erzeugen eines oszillierenden elektromagnetischen Felds konfiguriert ist, um ebenso als die rückseitige Elektrodenanordnung zu fungieren.

4. Drahtloses Leistungsübertragungspad (1) nach einem der Ansprüche 1 bis 2, ferner umfassend eine elektrisch leitfähige Lage (56), die konfiguriert ist, um als die rückseitige Elektrodenanordnung zu dienen.

5. Drahtloses Leistungsübertragungspad (1) nach Anspruch 4, wobei die elektrisch leitfähige Lage (56) zwischen dem Photovoltaiksubstrat (22) und der Vorrichtung (20) zum Erzeugen eines oszillierenden elektromagnetischen Felds angeordnet ist.

6. Drahtloses Leistungsübertragungspad (1) nach einem der Ansprüche 1 bis 5, ferner umfassend eine Antireflexionsschicht (51), die auf der Vorderseite (23) des Photovoltaiksubstrats (22) bereitgestellt ist.

7. Drahtloses Leistungsübertragungspad (1) nach einem der Ansprüche 1 bis 6, ferner umfassend eine vorderseitige Abdeckung (27) und eine rückseitige Abdeckung (28) zum Einkapseln und Schützen der Vorrichtung (20) zum Erzeugen eines oszillierenden elektromagnetischen Felds, der Fremdkörpererfassungsanordnung (25) und des Photovoltaiksubstrats (22).

8. Drahtloses Leistungsübertragungspad (1) nach Anspruch 7, ferner umfassend eine Antireflexionsschicht (52), die an der vorderen Abdeckung (27) bereitgestellt ist.

9. Drahtloses Leistungsübertragungspad (1) nach einem der Ansprüche 7 bis 8, wobei die vordere Abdeckung (27) transparent und durchdringbar für Sonnenstrahlung ist.

10. Drahtloses Leistungsübertragungspad (1) nach einem der Ansprüche 1 bis 9, wobei das Photovoltaiksubstrat (22) eine vorstehende und/oder vertiefte Oberflächenstruktur (46, 53) aufweist, die als Halter für die Fremdkörpererfassungsspulen (26) und/oder eine Spule der Vorrichtung (20) zum Erzeugen eines oszillierenden elektromagnetischen Felds dient.

11. Drahtloses Leistungsübertragungspad (1) nach einem der Ansprüche 1 bis 10, wobei die vorderseitige Elektrodenanordnung zum Ermöglichen eines Elektronenflusses zwischen der Vorderseite (23) des Photovoltaiksubstrats (22) und der vorderseitigen Elektrodenanordnung konfiguriert ist und wobei die rückseitige Elektrodenanordnung zum Ermöglichen eines Elektronenflusses zwischen der Rückseite (24) des Photovoltaiksubstrats (22) und der rückseitigen Elektrodenanordnung konfiguriert ist.

12. Drahtloses Leistungsübertragungspad (1) nach einem der Ansprüche 1 bis 11, wobei eine vorderseitige Schicht (30) des Photovoltaiksubstrats (22) p-dotiert ist und eine rückseitige Schicht (31) des Photovoltaiksubstrats (22) n-dotiert ist, oder wobei eine vorderseitige Schicht (30) des Photovoltaiksubstrats (22) n-dotiert ist und eine rückseitige Schicht (31) des Photovoltaiksubstrats (22) p-dotiert ist.

13. Drahtloses Leistungsübertragungspad (1) nach einem der Ansprüche 1 bis 12, wobei die Fremdkörpererfassungsanordnung (25) ein Array von mindestens 4, speziell mindestens 12 und spezieller mindestens 20 einzelnen Fremdkörpererfassungsspulen (26) einschließt, die über einen oberen Bereich des drahtlosen Leistungsübertragungspads (1) verteilt sind.

14. System, umfassend ein drahtloses Leistungsübertragungspad (1) nach einem der vorstehenden Ansprüche und ein Hybridelektro- oder Elektrofahrzeug mit einem elektrischen Speichersystem und einem drahtlosen Leistungsempfänger (4), wobei eine Vorrichtung (20) zum Erzeugen eines oszillierenden elektromagnetischen Felds des drahtlosen Leistungsübertragungspads (1) zum Übertragen von Energie an den drahtlosen Leistungsempfänger (4) des Fahrzeugs konfiguriert ist.

15. Verfahren zum drahtlosen Laden eines elektrischen Speichersystems eines Hybridelektro- oder Elektrofahrzeugs, umfassend:
Liefern von elektrischer Leistung, die durch eine Solarplattenanordnung (21) erzeugt wird, die in einem stationären drahtlosen Leistungsübertragungspad (1) integriert ist, an ein elektrisches Netz (7) oder ein lokales stationäres elektrisches Speichersystem (15), wobei die Solarplattenanordnung (21) ein Photovoltaiksubstrat (22) mit einer Vorderseite (23) und einer Rückseite (24), eine vorderseitige Elektrodenanordnung und eine rückseitige Elektrodenanordnung einschließt,
derartiges Positionieren des Hybridelektro- oder Elektrofahrzeugs über dem drahtlosen Leistungsübertragungspad (1), dass das drahtlose Leistungsübertragungspad (1) angrenzend an einen drahtlosen Leistungsempfänger (4) angeordnet ist, der dem Fahrzeug zugeordnet ist,
Erfassen, mittels einer Fremdkörpererfassungsanordnung (25), die in das drahtlose Leistungsübertragungspad (1) integriert ist, jedes Fremdkörpers, der sich auf dem drahtlosen Leistungsübertragungspad (1) befindet, wobei die Fremdkörpererfassungsanordnung (25) eine Vielzahl von Fremdkörpererfassungsspulen (26) einschließt, die konfiguriert sind, um ebenso als die vorderseitige Elektrodenanordnung zu fungieren,
falls kein Fremdkörper erfasst wird, Einleiten des Ladens des elektrischen Speichersystems (3) des Hybridelektro- oder Elektrofahrzeugs mit elektrischer Energie aus dem elektrischen Netz (7) oder dem lokalen stationären elektrischen Speichersystem (15) durch das Erzeugen eines oszillierenden elektromagnetischen Feldes, das in dem drahtlosen Leistungsübertragungspad (1) erzeugt wird und dadurch einen elektrischen Strom in dem drahtlosen Leistungsempfänger (4) induziert.

## Revendications

1. Tampon de transfert d'énergie sans fil (1) pour la charge sans fil d'un système de stockage électrique de véhicule, le tampon de transfert d'énergie sans fil (1) comprenant :
un dispositif de génération de champ électromagnétique oscillant (20) configuré pour transmettre de l'énergie à un récepteur de puissance sans fil (4) associé au véhicule,
un agencement de détection d'objets étrangers (25) comprenant une pluralité de bobines de détection d'objets étrangers (26), et
un agencement de panneaux solaires (21) comprenant un substrat photovoltaïque (22) avec un côté avant (23) et un côté arrière (24), un agencement d'électrodes de côté avant et un agencement d'électrodes de côté arrière,
dans lequel les bobines de détection d'objets étrangers (26) sont configurées pour fonctionner également en tant qu'agencement d'électrodes de côté avant.

2. Tampon de transfert d'énergie sans fil (1) selon la revendication 1, dans lequel le dispositif de génération de champ électromagnétique oscillant (20) comprend au moins une bobine (38, 39).

3. Tampon de transfert d'énergie sans fil (1) selon l'une quelconque des revendications 1 à 2, dans lequel le dispositif de génération de champ électromagnétique oscillant (20) est configuré pour fonctionner également en tant qu'agencement d'électrodes de côté arrière.

4. Tampon de transfert d'énergie sans fil (1) selon l'une quelconque des revendications 1 à 2, comprenant en outre une feuille électriquement conductrice (56) configurée pour servir de l'agencement d'électrodes de côté arrière.

5. Tampon de transfert d'énergie sans fil (1) selon la revendication 4, dans lequel la feuille électriquement conductrice (56) est disposée entre le substrat photovoltaïque (22) et le dispositif de génération de champ électromagnétique oscillant (20).

6. Tampon de transfert d'énergie sans fil (1) selon l'une quelconque des revendications 1 à 5, comprenant en outre une couche anti-réfléchissante (51) prévue sur le côté avant (23) du substrat photovoltaïque (22).

7. Tampon de transfert d'énergie sans fil (1) selon l'une quelconque des revendications 1 à 6, comprenant en outre un couvercle latéral avant (27) et un couvercle latéral arrière (28) pour encapsuler et protéger le dispositif de génération de champ électromagnétique oscillant (20), l'agencement de détection d'objets étrangers (25) et le substrat photovoltaïque (22).

8. Tampon de transfert d'énergie sans fil (1) selon la revendication 7, comprenant en outre une couche anti-réfléchissante (52) prévue sur le couvercle avant (27).

9. Tampon de transfert d'énergie sans fil (1) selon l'une quelconque des revendications 7 à 8, dans lequel le couvercle avant (27) est transparent et pénétrable pour le rayonnement solaire.

10. Tampon de transfert d'énergie sans fil (1) selon l'une quelconque des revendications 1 à 9, dans lequel le substrat photovoltaïque (22) présente une structure de surface en saillie et / ou en retrait (46, 53) servant de support pour les bobines de détection d'objets étrangers (26) et / ou une bobine du dispositif générateur de champ électromagnétique oscillant (20).

11. Tampon de transfert d'énergie sans fil (1) selon l'une quelconque des revendications 1 à 10, dans lequel l'agencement d'électrodes de côté avant est configuré pour permettre un flux d'électrons entre le côté avant (23) du substrat photovoltaïque (22) et l'agencement d'électrodes de côté avant, et dans lequel l'agencement d'électrodes de côté arrière est configuré pour permettre un flux d'électrons entre le côté arrière (24) du substrat photovoltaïque (22) et l'agencement d'électrodes de côté arrière.

12. Tampon de transfert d'énergie sans fil (1) selon l'une quelconque des revendications 1 à 11, dans lequel une couche de côté avant (30) du substrat photovoltaïque (22) est dopée p, et une couche de côté arrière (31) du substrat photovoltaïque (22) est dopé n, ou dans lequel une couche de côté avant (30) du substrat photovoltaïque (22) est dopée n, et une couche de côté arrière (31) du substrat photovoltaïque (22) est dopée p.

13. Tampon de transfert d'énergie sans fil (1) selon l'une quelconque des revendications 1 à 12, dans lequel l'agencement de détection d'objets étrangers (25) comprend un réseau d'au moins 4, spécifiquement d'au moins 12, et plus spécifiquement d'au moins 20 bobines individuelles de détection d'objets étrangers (26) répartis sur une zone supérieure du tampon de transfert d'énergie sans fil (1).

14. Système comprenant un tampon de transfert d'énergie sans fil (1) selon l'une quelconque des revendications précédentes, et un véhicule hybride électrique ou électrique avec un système de stockage d'électricité et un récepteur d'énergie sans fil (4), dans lequel un dispositif de génération de champ électromagnétique oscillant (20) du tampon de transfert d'énergie sans fil (1) est configuré pour transmettre de l'énergie au récepteur d'énergie sans fil (4) du véhicule.

15. Procédé de charge sans fil d'un système de stockage électrique d'un véhicule hybride électrique ou électrique comprenant :
la fourniture de l'énergie électrique générée par un agencement de panneaux solaires (21) intégré dans un tampon de transfert d'énergie sans fil stationnaire (1) à un réseau électrique (7) ou à un système de stockage électrique stationnaire et local (15), l'agencement de panneaux solaires (21) comprenant un substrat photovoltaïque (22) avec un côté avant (23) et un côté arrière (24), un agencement d'électrodes de côté avant et un agencement d'électrodes de côté arrière,
le positionnement du véhicule hybride électrique ou électrique sur le tampon de transfert d'énergie sans fil (1), si bien que le tampon de transfert d'énergie sans fil (1) est disposée adjacent à un récepteur d'énergie sans fil (4) associé au véhicule,
la détection, au moyen d'un agencement de détection d'objets étrangers (25) intégré dans le tampon de transfert d'énergie sans fil (1), de tout objet étranger situé sur le tampon de transfert d'énergie sans fil (1), l'agencement de détection d'objets étrangers (25) comprenant une pluralité de bobines de détection de corps étrangers (26) configurées pour fonctionner également en tant qu'agencement d'électrodes de côté avant,
si aucun objet étranger n'est détecté, l'initialisation de la charge du système de stockage électrique (3) du véhicule hybride électrique ou électrique avec de l'énergie électrique provenant du réseau électrique (7) ou du système de stockage électrique stationnaire et local (15) en générant un champ électromagnétique oscillant générant dans le tampon de transfert d'énergie sans fil (1) et ainsi induire un courant électrique dans le récepteur d'énergie sans fil (4).
